# EUROPEAN PATENT APPLICATION

(11) **EP 0 731 501 A1**
(43) Date of publication of application: **11.09.1996**
(21) Application number: 95480015.7
(22) Date of filing: 08.03.1995
(51) Int. Cl.: H01L 21/321

(54) **Method for plasma etching an oxide/polycide structure**

(71) Applicant: International Business Machines Corporation, Armonk, N.Y. 10504 (US)
(72) Inventor: Costaganna, Pascal, F-77930 Chailly en Biere (FR); Martinet, François, F-77310 Boissise le Roi (FR)
(74) Representative: Klein, Daniel Jacques Henri

(57) **Abstract**

According to the method of the present invention, a semiconductor structure (10') including a stack comprised of a cap SiO2 oxide layer (15), a tungsten silicide layer (14) and a bottom polysilicon layer (13) formed onto a silicon substrate (11) coated by a thin oxide layer (12) is patterned in a two-step plasma process with a resist stripping/cleaning step therebetween. After a resist mask (16) is formed at the top of the structure, the cap SiO2 layer is etched as standard in a first chamber of a multi-chamber MERIE reactor using a CHF3, O2 and Ar chemistry. Then, the semiconductor structure is removed from the reactor. The resist mask is eliminated by O2 ashing as standard and the wafer cleaned using DHF (100:1). Next, the structure is introduced in a second chamber of the RIE reactor, and the WSi2 and polysilicon layers are etched in sequence using the patterned cap SiO2 layer as a hard mask with adequate chemistries. A mixture of HCl, Cl2 and N2 is adequate for tungsten silicide etching and a mixture of HCl, He and He-O2 is adequate for polysilicon etching. The thin oxide layer is attacked to a very small extent during this step. Finally, the semiconductor structure is removed from the reaction chamber and is ready for subsequent processing. The improved etching method finds extensive application in the semiconductor industry and in particular in the formation of the gate conductor stack in 16 Mbit DRAM chips.

## Description

### FIELD OF INVENTION

The present invention relates to the manufacture of semiconductor integrated circuits and more particularly to an improved method for plasma etching an oxide/polycide structure consisting of a top silicon oxide (SiO2) layer, an intermediate refractory metal silicide layer and a bottom polycrystalline silicon (polysilicon) layer forming a stack. In a particular implementation which is commonly found in 16 Mbit DRAM chips wherein each individual memory cell is comprised of an IGFET transistor and a storage capacitor, such a stack is formed onto a silicon substrate coated with a thin layer of silicon oxide, which serves as the gate dielectric of the said IGFET transistors. In this case, the stack is usually referred to in the technical literature as the gate electrode stack. During fabrication, this stack is patterned to define the gate electrode lines or more generally the gate conductor lines because they are also used as the word lines in the memory array.

### BACKGROUND OF THE INVENTION

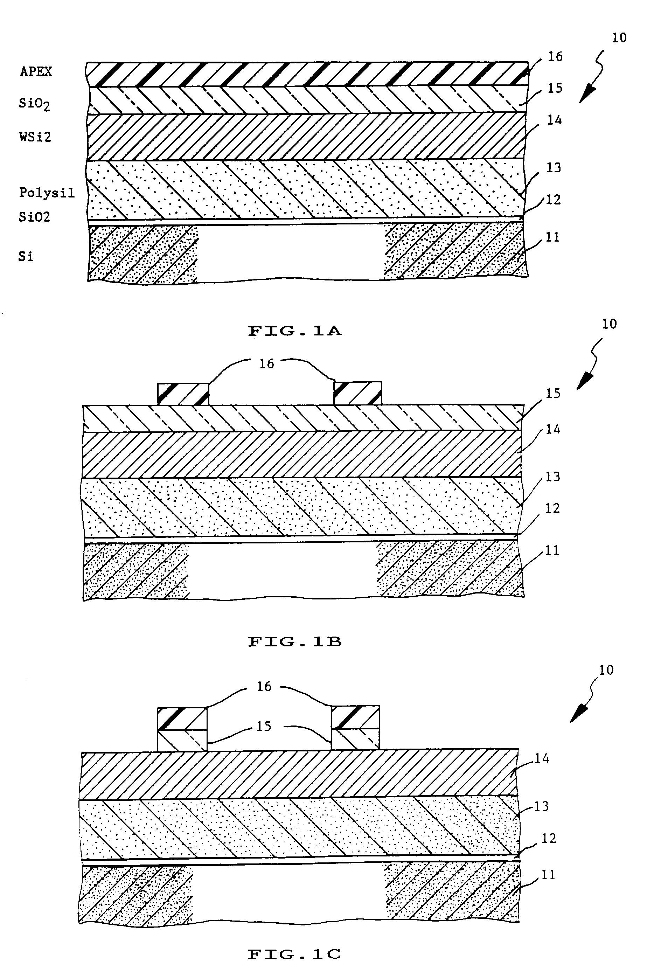

Fig. 1A schematically illustrates a portion of a wafer wherein the 16 Mbit DRAM chips mentioned above are fabricated. As apparent from Fig. 1A, there is shown a semiconductor structure 10 essentially comprised of a silicon substrate 11 coated by a thin SiO2 layer 12 with the gate conductor stack comprised of the plurality of layers recited above formed thereon. In the present instance, the stack consists of a bottom 230 nm thick polysilicon layer 13, an intermediate 250 nm thick tungsten silicide layer 14 and a top 400 nm layer 15. A photoresist layer 16 is formed on the stack to terminate the structure 10. All these layers, except however the photoresist layer, are formed by CVD (Chemical Vapor Deposition) techniques as standard. Preferably, the cap relatively thick SiO2 layer 15 is formed by low temperature PECVD (Plasma Enhanced Chemical Vapor Deposition) using Tetra Ethyl Ortho Silicate (TEOS) and oxygen for improved densification. The deposition of a refractory metal silicide over a layer of polysilicon is extensively used in the semiconductor industry, forming a dual structure usually referred to as a polycide layer. Refractory metals (generically referred to by letter M) include titanium (Ti), molybdenum (Mo), zirconium (Zr), tungsten (W) and tantalum (Ta). The photoresist layer 16 is applied by spin-on deposition technique on the wafer as standard. Once patterned, the photoresist layer 16 will be used as the etching mask for the gate conductor stack delineation. In cases there are notable parasitic reflections in the optical stepper, the use of a commercially available antireflective coating (ARC) is recommended as known for those skilled in the art. The 16 Mbit DRAM chips manufactured uses APEX-M (a high speed version of APEX). This photosensitive material is a 5-mJ positive tone chemically amplified system that has demonstrated excellent image stability, possibly with the use of an overcoat. The fabrication of the gate conductor lines is known to be one of the most critical processing steps of the manufacturing of such 16 Mbit DRAM chips, because of the different chemistries and etch rates that are required to selectively etch the different materials forming the stack without damaging the thin silicon oxide layer 12. Typically, to date, the fabrication of the gate conductor lines is performed in a multi-chamber reactive ion etching reactor and requires four reaction chambers to process the wafers as it will be made apparent hereafter. Preferably, a Magnetically Enhanced Reactive Ion Etching (MERIE) reactor, such as model AME 5000 manufactured by Applied Materials, Santa Clara, CA, USA is used for all these etching steps. The standard gate conductor line forming process will be now described in details by reference to Figs. 1B to 1F.

### RESIST PATTERNING

The gate conductor stack delineation process starts with the patterning of the photoresist layer 16 to produce the etching mask illustrated in Fig. 1B that is necessary for the subsequent etching steps. The patterning process includes the standard resist expose, post-expose bake and develop steps.

### CAP SiO2 ETCHING

Now, the cap SiO2 layer 15 must be etched. The cap SiO2 layer is etched in a first chamber of the MERIE reactor using a CHF3 chemistry with additional O2 and Ar gases to avoid high polymerization of fluorocarbon compounds on the edges of the gate conductor lines in order to get vertical profiles. The wafer that is placed on the cathode is cooled by a flow of helium at a determined pressure to reach the desired temperature. The walls of the chamber and the cathode are heated as standard. Operating conditions read as follows:

| | |
|---|---|
| CHF3 flow rate | 50 sccm |
| O2 flow rate | 8 sccm |
| Ar flow rate | 100 sccm |
| time | 180 sec |
| gas pressure | 18,7 Pa (140 mTorr) |
| microwave power | 850 W (at 13,56 MHz) |
| backside cooling | 800 Pa (6 Torr) |

This etching step requires high energy to insure anisotropic etching of the TEOS material. This first etching step is very critical because it is key to get the desired linewidth. Therefore, it is essential to have the adequate polymerisation balancing which essentially depends of gas mixture ratio. The resulting structure is shown in Fig. 1C.

### WSi2 ETCHING

The next step consists to transfer the pattern in the underlying tungsten silicide layer 15. Operating conditions now read as follows:

| | |
|---|---|
| BCl3 flow rate | 15 sccm |
| Cl2 flow rate | 115 sccm |
| time | 60 sec |
| gas pressure | 2,66 Pa (20 mTorr) |
| microwave power | 500 W |
| backside cooling | 270 Pa (2 Torr) |

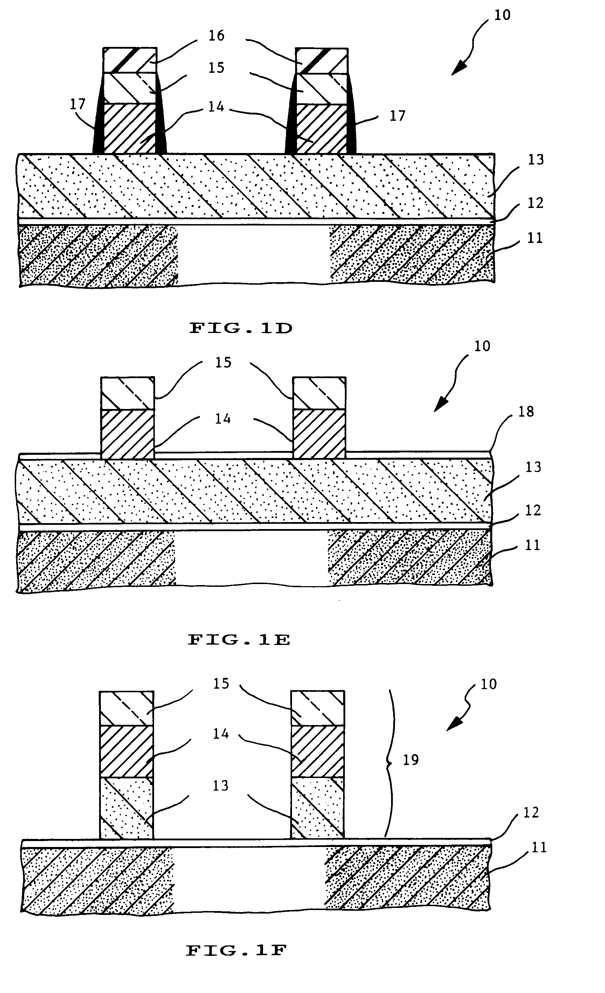

During this step, the carbon compounds of the resist layer 16 react with chlorine to produce a carbonated compound which is deposited forming sidewall buildups 17 on the patterns, as illustrated in Fig.1D. On the one hand, these sidewall buildups 17 are very useful because they provide a passivation of the patterns preventing thereby the undesired etching of the WSi2 material during this step and the subsequent step of etching the polysilicon layer 13 that would otherwise produce undercuts. On the other hand, this step is extremely dirty, because firstly layer 14 is not an homogeneous layer (the metal composition varies with the thickness) and secondly, due to the presence of the resist mask 16 which includes carbonated compounds. In addition, the WSi2 layer 14 is the most complex layer to be etched. As a matter of fact, this step is an important source of contamination and a major cause in the reactor lifetime reduction. Etching the WSi2 layer 15 with a BCl3/Cl2 chemistry generates different by-products such as WCl6 and SiCl4 which are volatile at high temperature forming deposits on the walls and the cathode of the chamber that are heated. BCl3 reveals to be efficient to anisotropically etch WSi2 but it has some negative effects such as degradation and undesired condensation effects in the feeding pipes. In addition, if the profile that is obtained is pretty vertical on the nested gate conductor lines, on the contrary, isolated gate conductor lines show slopes, and these effect is even more important at the edge of the wafer. The present step is accomplished in a second chamber of the MERIE reactor.

### RESIST STRIPPING/BREAKTHROUGH

The following step illustrated by Fig. 1E consists in a typical resist stripping sequence in a third chamber of the MERIE reactor using oxygen plasma, according to the following operating conditions:

| | |
|---|---|
| O2 flow rate | 50 sccm |
| time | 90 sec |
| gas pressure | 40 Pa (300 mTorr) |
| microwave power | 300 W |
| backside cooling | 2 Torr |

Because, the top surface of the polysilicon layer is exposed during this resist stripping step which employs an oxygen plasma, a superficial layer 18 of native SiOx oxide is created. Therefore, an additional processing step is required to remove the native oxide layer 18 as known for those skilled in the art. This step, which is usually referred to as the breakthrough step, is still accomplished by RIE etching in the same third chamber of the reactor according to the following operating conditions:

| | |
|---|---|
| CF4 flow rate | 18 sccm |
| time | 20 sec |
| gas pressure | 2,66 Pa (20 mTorr) |
| microwave power | 350 W |
| backside cooling | 2 Torr |

At this stage of the processing, the semiconductor structure 10 is shown in Fig. 1E.

### POLYSILICON ETCHING

Finally, in the fourth chamber of the MERIE reactor, the polysilicon layer 13 is etched using an HCl, He-O2 and He mixture. The operating conditions read as follows:

| | |
|---|---|
| HCl flow rate | 40 sccm |
| He-O2 flow rate | 12 sccm |
| He flow rate | 70 sccm |
| time | 280 sec |
| gas pressure | 2,66 Pa (20 mTorr) |
| microwave power | 150 W |
| backside cooling | 8 Torr |

HCl is used because it generates less chlorine, so reducing WSi2 lateral etching. The He-O2 gas mixture (ratio: 60/40) insures the desired high selectivity between the polysilicon material of layer 13 and the silicon oxide of layer 12. He is needed for diluting the oxygen in the He-O2 mixture to guarantee the optimum oxygen balancing. Fig. 1F shows the semiconductor structure at the final stage of the process wherein the gate conductor line is referenced 19.

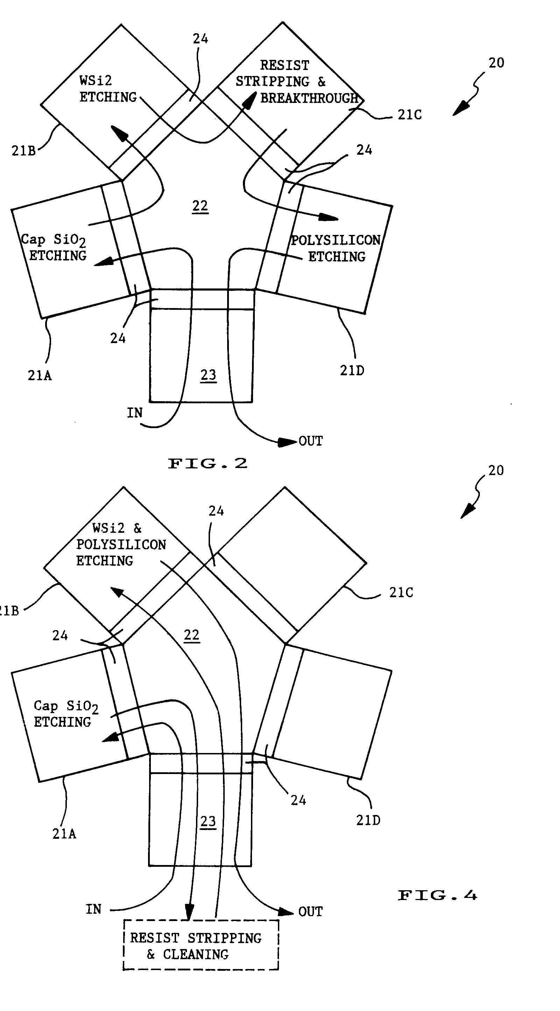

The above described state of the art process is illustrative of a typical gate conductor line formation process for a 16 Mbit DRAM chip. It may be referred to as a clustered process because all the processing steps are performed without extracting the wafer from the multi-chamber MERIE reactor for the whole sequence of steps. Fig. 2 schematically shows such a multi-chamber MERIE reactor referenced 20 wherein the chambers bear numerals 21A to 21D. A central load/unload module 22 is disposed concentrically within the reactor 20 and a queuing station 23 is coupled to the load/unload module for transferring the wafers therein for processing and after processing from the reactor to the outside world. Vacuum locks generally designated 24 are individually provided at the interface of the chambers and the load/unload module and between the interface of the latter and the queueing station. The other parts of the reactor (processor, vacuum systems, ...) have not been shown for sake of simplicity. Assuming the wafers are processed in adjacent chambers, the different travels the wafers are submitted to are clearly illustrated in Fig. 2. As apparent from Fig. 2, because four different plasma compositions are used in said four chambers, every time a plasma is extinct before a wafer is transferred from one chamber to another one, some by-products produced in this step are deposited onto the wafer. These by-products may be an important source of particulate contamination because there is no cleaning step performed in the central load/unload module 22.

Unfortunately, the above described method has a number of drawbacks. First of all, it is a highly contaminating process. In particular, the WSi2 etching step is a very dirty step because the presence of the polymeric resist mask 16 which inherently is an important source of contamination. As a result, the chamber dedicated to this step is cleaned every 45 hours. On the other hand, the multiple plasma extinctions are also known to be another important source of contamination which significantly impacts the photo limited yield PLY (etch micromasking defects), which in turn, has a direct effect on the final wafer test yield. Likewise, there is obviously a strong cross contamination from chamber to chamber. Besides the contamination aspect, other inconveniences include: the requirement of a breakthrough step, the resist stripping which is performed in a chamber of a RIE reactor and not in a specific tool, and the sloped profile of gate conductor lines that are isolated or located at wafer edge producing a detrimental high linewidth variation all across the wafer. Moreover, this method requires four chambers with no tool flexibility because fully dependant of the four chamber uptime, with frequent wet cleaning of the chambers. Finally, the prior art method has low throughputs and high manufacturing costs.

### SUMMARY OF THE PRESENT INVENTION

The present invention aims to get rid of these drawbacks. According to the present invention there is disclosed a method for dry (plasma) etching of an oxide/polycide structure. In a preferred embodiment, a semiconductor structure consisting of a polycide layer sandwiched between a cap relatively thick SiO2 layer (other insulating materials such as Si3N4 may be used as well) and a thin oxide layer formed onto a silicon substrate is patterned in a two step plasma process with a resist stripping and cleaning step therebetween. The layer of thin oxide is attacked to a very small extent. A typical process step sequence reads as follows. After a photoresist etching mask has been provided at the top of the said structure, the cap TEOS layer is etched as standard in a first chamber of a multi-chamber RIE reactor using a CHF3, O2 and Ar chemistry. Then, the semiconductor structure is removed from the reactor (declustering). The resist etching mask is stripped by O2 ashing in a specific tool and the wafer cleaned using DHF (100:1) to eliminate resist residues and particulates existing on the wafer surface. Next, the structure is introduced in a second chamber of the RIE reactor, and the metal silicide (e.g. tungsten silicide) and polysilicon layers are etched in sequence using the patterned cap SiO2 layer as a hard mask with different but compatible chemistries with no plasma extinction therebetween. The first chemistry for etching the tungsten silicide layer consists of a mixture of HCl, Cl2 and N2. The second chemistry for etching the polysilicon layer consists of a mixture of HCl, He-O2 and He. Finally, the semiconductor structure is removed from the reaction chamber, cleaned and is then ready for subsequent processing. The improved method of the present invention is substantially contamination-free, in particular, no breakthrough step is required any longer. The resist stripping is performed by ashing in O2 is now advantageously performed in a specific tool. As a final result, only two reaction chambers are now necessary to implement the said improved method instead of four with the prior art etching method. The improved etching method of the present invention finds extensive application in the semiconductor industry and in particular, in the formation of the gate conductor lines in 16 Mbit DRAM chips.

### OBJECTS OF THE PRESENT INVENTION

It is therefore a primary object of the present invention to provide an improved method for plasma etching an oxide/polycide structure consisting of a cap SiO2 layer, a refractory metal silicide layer, and a bottom polysilicon layer which is substantially contamination-free.

It is another object of the present invention to provide an improved method for plasma etching an oxide/polycide structure consisting of a cap SiO2 layer, a refractory metal silicide layer, and a bottom polysilicon layer which does not substantially differentiate between gate conductor lines irrespective they are nested or isolated or located at the center or at the edge of the wafer to produce these lines with the desired vertical profile everywhere.

It is another object of the present invention to provide an improved method for plasma etching an oxide/polycide structure consisting of a cap SiO2 layer, a refractory metal silicide layer, and a bottom polysilicon layer which significantly improves the photo limited yield PLY and thus the final test yield.

It is another object of the present invention to provide an improved method for plasma etching an oxide/polycide structure consisting of a cap SiO2 layer, a refractory metal silicide layer, and a bottom polysilicon layer which only requires two plasma etching steps with a resist stripping/cleaning step therebetween.

It is another object of the present invention to provide an improved method for plasma etching an oxide/polycide structure consisting of a cap SiO2 layer, a refractory metal silicide layer, and a bottom polysilicon layer which uses the cap SiO2 layer once patterned as a hard mask instead of a photomask for etching the underlying layer.

It is another object of the present invention to provide an improved method for plasma etching an oxide/polycide structure consisting of a cap SiO2 layer, a refractory metal silicide layer, and a bottom polysilicon layer which etches the metal silicide layer and the polysilicon layer in a single step with two different but compatible chemistries with no plasma extinction therebetween.

It is another object of the present invention to provide an improved method for plasma etching an oxide/polycide structure consisting of a cap SiO2 layer, a refractory metal silicide layer, and a bottom polysilicon layer which does not require a breakthrough step.

It is another object of the present invention to provide an improved method for plasma etching an oxide/polycide structure consisting of a cap SiO2 layer, a refractory metal silicide layer, and a bottom polysilicon layer wherein the resist stripping is performed in a specific tool for better efficiency and cleanliness.

It is still another object of the present invention to provide an improved method for plasma etching an oxide/polycide structure consisting of a cap SiO2 layer, a refractory metal silicide layer, and a bottom polysilicon layer which only requires two reaction chambers instead of four for increased throughputs and reduced manufacturing costs.

The novel features believed to be characteristic of this invention are set forth in the appended claims. The invention itself, however, as well as other objects and advantages thereof, may be best understood by reference to the following detailed description of an illustrated preferred embodiment to be read in conjunction with the accompanying drawings.

### BRIEF DESCRIPTION OF THE DRAWINGS

Fig. 1A shows a semiconductor structure that includes five superposed layers forming a stack in which the gate conductor lines will be defined.

Figs. 1B to 1F show the semiconductor structure of Fig. 1A at different stages of the fabrication of the gate conductor lines according to a standard process of the prior art.

Fig. 2 schematically shows the wafer transfers between the four chambers of the MERIE reactor when said standard process is employed.

Figs. 3A to 3C show the semiconductor structure of Fig. 1A at different stages of the fabrication of the gate conductor lines according to the method of the present invention.

Fig. 4 schematically shows the wafer transfers between two chambers of the MERIE reactor when the method of the present invention is employed.

### DESCRIPTION OF THE PREFERRED EMBODIMENTS

### CAP SiO2 ETCHING

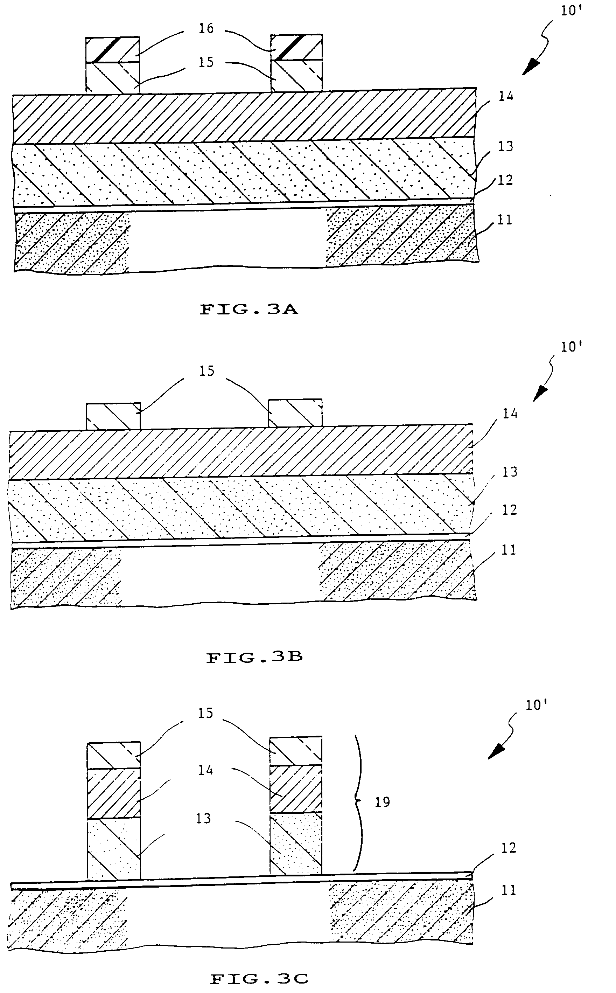

According to the improved method of the present invention, the semiconductor structure of Fig. 1A is submitted to the same steps of patterning the resist layer 16 to produce an etching mask and then of etching the cap SiO2 layer 15. Likewise, this step of etching is performed in the first chamber 21A of the MERIE reactor 20. As a result, the initial semiconductor structure to be processed according to the method of the present invention is the structure 10 at the stage illustrated in Fig. 1C. The novel improved method will be now described by reference to Figs. 3A to 3C, wherein Fig. 3A is structurally identical in all respects to Fig. 1C and the same elements will be designated by the same references for sake of simplicity.

### RESIST STRIPPING AND CLEANING

At this stage of the processing, the semiconductor structure now referenced 10' is extracted from the reaction chamber 21A to remove the resist layer 16 forming the etching mask. This step is advantageously accomplished in a specific tool provided with a hot plate using ozone as standard. An adequate equipment is model 200 AC II ASHER sold by FUSION SEMICONDUCTOR SYSTEMS. Other advantages resulting of this processing step are more efficient stripping and higher throughput.

Next, the semiconductor structure 10' is cleaned by any dry or wet cleaning technique. For instance, the structure 10' is dipped in a diluted hydrofluoric acid bath (100:1) for 15 sec. The resulting structure is shown in Fig. 3B. This wet cleaning step during a short time has several benefits. As a matter of fact, organic and inorganic residues that result from resist ashing and from cross contamination are removed, thereby creating a cleaner surface of the WSi2 layer 14. As a consequence, the etch micromasking defects are lowered. These defects are known to be critical to the process because they may result in a number of potential failures after completion of the process, such as polysilicon shorts or extensions between two adjacent gate conductor lines.

### WSi2 and POLYSILICON ETCHING

Now the semiconductor structure 10' is introduced in another reaction chamber, e.g. 21B of the MERIE reactor 20. The chamber is still heated, the temperatures of the cathode and of the walls are 17°C and 45°C respectively. Using the patterned cap SiO2 layer 15 as an hard etching mask, the exposed portions of the tungsten silicide WSi2 layer 14 and of the polysilicon layer 13 are etched seriatim. First, a mixture of HCl, Cl2 and N2 is used for tungsten silicide etching according to the following parameters:

| | |
|---|---|
| HCl flow rate | 15 sccm |
| Cl2 flow rate | 90 sccm |
| N2 flow rate | 2 sccm |
| time | 75 sec |
| gas pressure | 2,66 Pa (20 mTorr) |
| microwave power | 450 W |
| backside cooling | 8 Torr |

Next, to etch the polysilicon layer 13, a HCl, He-O2 and He chemistry is used with the following operating conditions:

| | |
|---|---|
| HCl flow rate | 40 sccm |
| He-O2 flow rate | 12 sccm |
| He flow rate | 70 sccm |
| time | 280 sec |
| gas pressure | 2,66 Pa (20 mTorr) |
| microwave power | 150 W |
| backside cooling | 8 Torr |

It is to be noticed that the same gas pressure is maintained in the chamber during the etching of the polycide layer, only the nature and flow of reactive gases are changed in this step. The two HCl based chemistries are perfectly compatible. At the end of the etch process, the resulting structure is shown in Fig. 3C where the gate conductor lines are still referenced 19. No significant attack of the thin SiO2 layer 12 has been noticed. An essential feature of the improved method of the present invention is the use of the cap SiO2 layer 15 (once patterned) as an in-situ hard mask during the WSi2 layer 14 and polysicon layer 13 etching. Moreover, these two layers are etched in a single step, therefore without plasma extinction therebetween, significantly reducing thereby the particulate contamination which normally results from the use of various chemistries in the different chambers of the MERIE reactor 20 and the fall of by-product particles which occurred with the prior art method at each plasma extinction when the wafer was transferred from one chamber to another one. Finally, the use of the HCl based chemistries with the cap SiO2 hard mask permits an accurate control of the vertical profile, which results in reduced sidewall organic/inorganic deposition, less microloading effects at plasma extinction and reduced etch bias (by a factor of about 35%) between the two types of gate conductor lines (nested vs isolated). The breakthrough step which was needed just before polysilicon etching to "break" the native oxide layer 18 (see Fig. 1E) is no longer required, dividing by a factor of two the particulate contamination due to O2 and CF4 combined effects in the MERIE reactor 20.

The new roadmap showing the movements of the wafer within the MERIE reactor 20 is illustrated in Fig. 4. As apparent from Fig. 4, only two reaction chambers, in this instance chambers 21A and 21B, are required. The cap SiO2 layer is patterned in chamber 21A and the polycide layer 13/14 is etched in chamber 21B. The two other chambers 21C and 21D may be used to process another lot of wafers. The resist stripping and cleaning step is performed outside the MERIE reactor 20.

The method of the present invention can thus be clearly distinguished from the above described state of the art process. It is based on a new sequence of two etching steps, each being performed in a reaction chamber of the MERIE reactor, with a declustering therebetween for resist stripping and cleaning the wafer. The resist stripping is performed in a specific tool and the standard breakthrough step is no longer required. Moreover, it uses the patterned cap SiO2 layer as a hard mask for the etching of both the tungsten silicide and polysilicon layers in the same chamber with adequate and compatible chemistries. As a result, the particulate contamination is substantially eliminated.

The method of the present invention has some significant advantages when compared to the prior art method that will be now recited. It is a substantially contamination-free process, because first there is no plasma extinction between WSi2 and polysilicon etching, and second there is a cleaning step either before or after every plasma extinction. In addition, there is no longer any carbon polymerization because the breakthrough step (which employs CF4) has been eliminated. Less contamination means photo limited yield and final test yield improvements due to lower defect density. Gate conductor lines with a vertical profile are obtained irrespective their location, at the center or at the wafer edge, producing thereby a significant chip linewidth variation improvement for the whole wafer. Resist stripping is performed in much better conditions because this step is now made in a specific tool. Only two reaction chambers are now required instead of four, offering thereby higher tool capacity by a factor of two with more flexibility and improved uptime. The dry (plasma) etching method of the present invention finds extensive application in the semiconductor industry and in particular, in the formation of the gate conductor lines in 16 Mbit DRAM chips.

## Claims

1. A method for dry etching an insulating material/polycide structure Consisting of a top layer (15) of an insulating material, an intermediate layer of a refractory metal silicide MSi2 (14) and a bottom polysilicon layer (13) forming a stack deposited onto a substrate (11, 12) comprising the steps of:
forming an etching mask (16), typically of photoresist, on said insulating layer having a desired pattern;
transferring said pattern to said insulating layer as standard in a first reaction chamber of a plasma reactor;
removing the structure from the chamber;
eliminating the etching mask and cleaning the structure; and,
etching the structure in a second reaction chamber of the plasma reactor using the patterned insulating layer as an in-situ hard mask to remove the exposed portions first of the refractory metal silicide layer with a first chemistry, then of the polysilicon layer with a second chemistry without plasma extinction therebetween, said chemistries being compatible.

2. The method of claim 1 wherein the insulating material is SiO2 and said substrate consists of a silicon substrate (11) coated by a thin SiO2 layer (12).

3. The method of claim 1 or 2 wherein said chambers are two dedicated chambers (21A & 21B) of a single multi-chamber MERIE reactor (20).

4. The method of claim 1, 2 or 3 wherein said refractory metal is selected in the group comprising: tungsten, titanium, molybdenum, tantalum and zirconium.

5. The method of claim 4 wherein said refractory metal is tungsten.

6. The method of claim 5 wherein the first chemistry for etching the tungsten silicide layer is a mixture of HCl, Cl2 and N2.

7. The method of claim 6 wherein the typical operating conditions are given by the following parameters:
| | |
|---|---|
| HCl flow rate | 15 sccm |
| Cl2 flow rate | 90 sccm |
| N2 flow rate | 2 sccm |
| time | 75 sec |
| gas pressure | 2,66 Pa (20 mTorr) |

8. The method of any claim 4 to 7 wherein the second chemistry for etching the polysilicon layer is a mixture of HCl, He-O2 and He.

9. The method of claim 7 wherein the typical operating conditions are given by the following parameters:
| | |
|---|---|
| HCl flow rate | 40 sccm |
| He-O2 flow rate | 12 sccm |
| He flow rate | 70 sccm |
| time | 280 sec |
| gas pressure | 2,66 Pa (20 mTorr) |
| microwave power | 150 W |
| backside cooling | 8 Torr |

10. The method of any above claim wherein said resist stripping is performed by O2 ashing and said cleaning is performed by dipping the structure in a DHF (100:1) bath.

11. A method of manufacturing a semiconductor structure (10') including the steps of:
a) providing a semiconductor substrate (11);
b) forming a thin dielectric layer (12) thereon;
c) depositing a layer (13) of polysilicon on top of the thin dielectric layer;
d) depositing a layer (14) of refractory metal silicide on top of the polysilicon layer;
e) depositing a layer (15) of SiO2 on top of the refractory metal silicide layer;
f) forming an etching mask (16), typically a photoresist mask, having a desired pattern on top of the SiO2 layer;
g) transferring said pattern to the SiO2 layer as standard in a first reaction chamber of a plasma reactor;
h) removing the structure from the said chamber;
i) eliminating the etching mask and cleaning the structure; and,
j) etching the structure in a second reaction chamber of the plasma reactor using the patterned SiO2 layer as an in-situ hard mask to remove the exposed portions, first of the refractory metal silicide layer with a first chemistry, then of the polysilicon layer with a second chemistry with no plasma extinctions therebetween, said chemistries being compatible.

12. The method of claim 11 wherein said reaction chambers are two dedicated chambers (21A & 21B) of a single multi-chamber RIE reactor (20).

13. The method of claim 11 or 12 wherein said refractory metal is selected in the group comprising: tungsten, titanium, molybdenum, tantalum and zirconium.

14. The method of claim 13 wherein said refractory metal is tungsten.

15. The method of claim 14 wherein the first chemistry for etching the tungsten silicide layer is a mixture of HCl, Cl2 and N2.

16. The method of claim 15 wherein the typical operating conditions are given by the following parameters:
| | |
|---|---|
| HCl flow rate | 15 sccm |
| Cl2 flow rate | 90 sccm |
| N2 flow rate | 2 sccm |
| time | 75 sec |
| gas pressure | 2,66 Pa (20 mTorr) |

17. The method of any claim 14 to 16 wherein the second chemistry for etching the polysilicon layer is a mixture of HCl, He-O2 and He.

18. The method of claim 17 wherein the typical operating conditions are given by the following parameters:
| | |
|---|---|
| HCl flow rate | 40 sccm |
| He-O2 flow rate | 12 sccm |
| He flow rate | 70 sccm |
| time | 280 sec |
| gas pressure | 2,66 Pa (20 mTorr) |
| microwave power | 150 W |
| backside cooling | 8 Torr |

19. The method of any above claim 11 to 18 wherein said resist stripping is performed by O2 ashing and said cleaning is performed by dipping the structure in a DHF (100:1) bath.
